# EUROPÄISCHE PATENTSCHRIFT

(11) **EP 1 306 949 B1**
(45) Veröffentlichungstag und Bekanntmachung des Hinweises auf die Patenterteilung: **04.08.2004**
(21) Anmeldenummer: 01125185.7
(22) Anmeldetag: 24.10.2001
(51) Int. Cl.: H02B 1/03, H02B 1/42

(54) **Zähler- und/oder Verteilervorrichtung**
Meter and/or distribution device
Compteur et/ou dispositif de distribution

(43) Veröffentlichungstag der Anmeldung: 02.05.2003
(73) Patentinhaber: Karl Kuklies GmbH, 47167 Duisburg (DE)
(72) Erfinder: Kuklies, Werner, c/o Karl Kuklies GmbH, 47167 Duisburg (DE)
(74) Vertreter: Rohmann, Michael, Dr.

(56) Entgegenhaltungen:
- EP-A- 0 351 279
- DE-A- 1 465 254
- US-A- 5 147 981

## Beschreibung

Die Erfindung betrifft eine Zähler- und/oder Verteilervorrichtung, mit einer rückseitigen Plattform, die insbesondere an einer Wand fixierbar ist. - Bei einer erfindungsgemäßen Zahler- und/oder Verteilervorrichtung handelt es sich nach bevorzugter Ausführungsform der Erfindung um eine Stromzähler- und Stromverteilervorrichtung. Derartige Vorrichtungen sind aus dem Stand der Technik unter der Bezeichnung Zählerschränke bekannt. Zählerschränke werden insbesondere in Gebäuden installiert und dienen dort der Messung des Stromverbrauchs sowie der vorgesehenen Verteilung des Stroms. Diese Zählerschränke weisen entsprechende Zählerkomponenten und Verteilerkomponenten auf, die an dem Zählerschrank befestigt sind.

Aus US 5 147 981 ist ein elektrischer Schaltschrank bekannt, der mit einer rückseitigen Plattform ausgestattet ist. Es sind Befestigungselemente vorgesehen, die an der rückseitigen Plattform befestigt sind und zwar über Haken, die in Perforationen der rückseitigen Plattform eingreifen. Außerdem sind Befestigungsschienen über Schrauben an die Befestigungselemente angeschlossen. Die Befestigung der Befestigungsschienen über Schraubverbindungen ist sowohl beim Herstellen als auch beim Lösen der Verbindungen sehr aufwendig. Fernerhin ist aus EP-A 0 351 279 ein Verfahren zur Montage von mindestens einem elektrischen Gerät auf einem Träger bekannt. Hier werden elektrische Komponenten an einem Rahmen bzw. Gestell befestigt. Dieses Gestell wird an einer rückseitigen Plattform fixiert, indem es an Haken eingehangt wird, die aus der rückseitigen Plattform vorstehen. Diese Fixierungsmaßnahmen sind nicht ausreichend funktionssicher und es resultieren häufig fehlerhafte Einhängungen. Wenn das Einhängen bzw. Aufhängen der Komponenten nicht völlig korrekt durchgeführt wurde, können beispielsweise Schräglagen der Komponenten die Folge sein und dadurch können wiederum elektrische Verbindungen derart belastet werden, dass sie zumindest langfristig ungewollt gelöst werden.

Weitere aus der Praxis bekannte Zähler- und Verteilervorrichtungen bzw. Zählerschränke bestehen normalerweise aus einer rückseitigen Plattform, zwei Seitenwänden, einer oberen Wand und einer unteren Wand (Bodenwand). Die rückseitige Plattform ist in der Regel für die Befestigung an einer Gebäudewand vorgesehen. Die Zählerkomponenten und die Verteilerkomponenten sind normalerweise zu größeren Aggregaten zusammengefasst und beispielsweise an Befestigungsschienen befestigt. Bei den bekannten Zahlerschränken sind diese Aggregate auf der Bodenwand des Zählerschrankes abgestützt bzw. an der Bodenwand befestigt. Die Befestigung der Aggregate aus Zählerkomponenten und Verteilerkomponenten an der Bodenwand oder an der rückseitigen Plattform erfolgt bei den bekannten Zahlerschränken über Schraubverbindungen. Die Bodenplatte übernimmt bei diesen bekannten Zählerschränken gleichsam die tragende Funktion für die Zählerkomponenten und Verteilerkomponenten. Wenn Zähler- und/oder Verteilerkomponenten gewartet, repariert oder ausgetauscht werden sollen, sind bei diesen bekannten Zählerschränken aufwendige bzw. komplizierte Demontagearbeiten notwendig. Im Übrigen handelt es sich bei den bekannten Zählerschränken um gewichtsmäßig schwere Aggregate. Eine untere Platte bzw. Bodenplatte ist hier zwingend erforderlich.

Demgegenüber liegt der Erfindung das technische Problem zugrunde, eine Zähler- und/oder Verteilervorrichtung anzugeben, bei der einerseits die Zählerkomponenten und Verteilerkomponenten auf einfache Art und Weise befestigt sind und bei der andererseits eine einfache und wenig aufwendige Wartung, Reparatur und Instandhaltung möglich ist.

Zur Lösung dieses technischen Problems lehrt die Erfindung eine Zähler- und/oder Verteilervorrichtung mit einer rückseitigen Plattform, die insbesondere an einer Wand fixierbar ist,
wobei zumindest zwei Befestigungsschienen vorgesehen sind, an denen Zählerkomponenten und/oder Verteilerkomponenten befestigt sind,
wobei die Befestigungsschienen ihrerseits über Rastverbindungen an der rückseitigen Plattform befestigt sind,
wobei auf der rückseitigen Plattform Befestigungsclips vorgesehen sind und wobei die Befestigungsschienen zur Verwirklichung der Rastverbindungen mit den Befestigungsklipps verrastbar sind
und wobei die rückseitige Plattform allein die tragende Funktion für die Befestigungsschienen mit den Zählerund/oder Verteilerkomponenten übernimmt.

Bei den Zählerkomponenten und den Verteilerkomponenten der erfindungsgemäßen Zähler- und/oder Verteilervorrichtung handelt es sich insbesondere um Stromzählerkomponenten und/oder Stromverteilerkomponenten. Bei den Verteilerkomponenten kann es sich aber auch um Komponenten für die Datenverteilung im Rahmen einer elektronischen Datenverarbeitung handeln. Zählerkomponenten und/oder Verteilerkomponenten meint nach einer Ausführungsform der Erfindung auch Komponenten einer Telefonanlage und/oder Komponenten für die Heizungssteuerung eines Gebäudes.

Zweckmäßigerweise besteht die rückseitige Plattform der erfindungsgemäßen Zähler- und/oder Verteilervorrichtung aus Metallblech. Nach einer Ausführungsform der Erfindung weist die aus Metallblech bestehende Plattform dabei an ihrer Vorderseite, das heißt befestigungsschienenseitig zumindest eine Kunststoffschicht auf. - Die rückseitige Plattform ist zweckmäßigerweise rechteckförmig ausgebildet. Nach einer Ausführungsform kann die Höhe 450 bis 1800 mm betragen, beispielsweise 900 mm. Die Breite der rückseitigen Plattform beträgt 250 bis 1250 mm, beispielsweise 500 mm.

Es liegt im Rahmen der Erfindung, dass die Befestigungsschienen im montierten Zustand vertikal ausgerichtet sind. Dabei sind die Befestigungsschienen zweckmäßigerweise parallel zueinander orientiert. Nach sehr bevorzugter Ausführungsform der Erfindung sind die Befestigungsschienen U-profilförmig ausgebildet, sie haben also im Querschnitt eine U-Form. Vorzugsweise sind im Rahmen der Erfindung vier Befestigungsschienen vorgesehen, die an der rückseitigen Plattform befestigt werden und dabei zweckmäßigerweise parallel zueinander orientiert sind.

Erfindungsgemäß sind die Befestigungsschienen über Rastverbindungen an der rückseitigen Plattform befestigt. Dabei liegt es im Rahmen der Erfindung, dass die Rastverbindungen wieder lösbar sind, um insbesondere ein Aggregat aus Befestigungsschienen und aus Zähler- und/oder Verteilerkomponenten problemlos von der rückseitigen Plattform abnehmen zu können. Vorzugsweise sind die Befestigungsschienen ausschließlich über Rastverbindungen an der rückseitigen Plattform befestigt. Grundsätzlich liegt es aber auch im Rahmen der Erfindung, dass zusätzlich Schraubverbindungen vorgesehen sind. Erfindungsgemäß sind auf der rückseitigen Plattform Befestigungsclips angeordnet und sind die Befestigungsschienen zur Verwirklichung der RastVerbindungen mit den Befestigungsclips verrastbar. Die Befestigungsclips sind also Rastelemente, die mit den Befestigungsschienen als Komplementärrastelemente verrastbar sind. Es liegt im Rahmen der Erfindung, dass ein Befestigungsclip beim Verrasten in eine offene Seite des U-Profils einer Befestigungsschiene einfasst. Vorzugsweise sind zumindest zwei Befestigungsclips pro Befestigungsschiene an der rückseitigen Plattform vorgesehen. Die Befestigungsclips können an der rückseitigen Plattform angeschraubt sein. Zweckmäßigerweise sind die Befestigungsclips rasterförmig auf der rückseitigen Plattform verteilt.

Nach sehr bevorzugter Ausführungsform der Erfindung sind zumindest vier zueinander parallele Befestigungsschienen vorgesehen und ist jeweils zumindest eine Zähler- und/oder Verteilerkomponente an zwei zueinander parallelen Befestigungsschienen befestigt. Nach einer Ausführungsform sind vier Befestigungsschienen vorgesehen und jede Zählerund/oder Verteilerkomponente ist an zwei Befestigungsschienen befestigt. Auf diese Weise erhält man zwei Bausätze mit Zähler- und/oder Verteilerkomponenten. Die beiden Befestigungsschienen befinden sich zweckmäßigerweise jeweils an den Außenrändern der jeweiligen Zähler- und/oder Verteilerkomponente. Eine Zähler- und/oder Verteilerkomponente überspannt dann gleichsam den Abstand zwischen den beiden Befestigungsschienen, an denen sie befestigt ist.

Nach einen Ausführungsform der Erfindung, ist ein Aggregat aus zwei zueinander parallelen Befestigungsschienen und zumindest einer daran befestigten Zähler- und/oder Verteilerkomponente als Ganzes an der rückseitigen Plattform verrastbar ist. Das vorgenannte Aggregat ist also als Ganzes an die rückseitige Plattform andrückbar und dabei verrastbar. Zweckmäßigerweise sind diese Rastverbindungen auch wieder lösbar. Vorzugsweise sind für ein Aggregat mit zwei zueinander parallelen Befestigungsschienen zumindest vier Befestigungsclipse an der rückseitigen Plattform vorgesehen. Nach einer bevorzugten Ausführungsform der Erfindung weist eine erfindungsgemäße Zähler- und/oder Verteilervorrichtung zwei nebeneinander angeordnete Aggregate auf, die jeweils aus zwei zueinander parallelen Befestigungsschienen und zumindest einer daran befestigten Zähler- und/oder Verteilerkomponente bestehen. Bei dieser Ausführungsform sind also gleichsam zwei Bausätze an der rückseitigen Plattform befestigbar. Bei den beiden Aggregaten kann es sich um einerseits ein Zähleraggregat und andererseits um ein Verteileraggregat handeln. Für diese beiden Aggregate sind zweckmäßigerweise zumindest acht Befestigungsclipse an der rückseitigen Plattform vorgesehen und zwar vorzugsweise zumindest vier Befestigungsclipse für jedes Aggregat.

Nach einer Ausführungsform der Erfindung sind Gehäusekomponenten in Form von zwei Seitenwänden, einer unteren Wand (Bodenwand) und einer oberen Wand an der rückseitigen Plattform befestigt. Diese Gehäusekomponenten können vorgesehen sein, sind aber im Rahmen der Erfindung keinesfalls zwingend erforderlich. Wesentlich ist dabei, dass diesen Gehäusekomponenten in Bezug auf die Befestigungsschienen und die daran befestigten Zähler- und/oder Verteilerkomponenten keinerlei tragende Funktion zukommt. Insbesondere die untere Wand (Bodenwand) hat im Gegensatz zum Stand der Technik keine tragende Funktion. Erfindungsgemäß übernimmt lediglich die rückseitige Plattform die genannte tragende Funktion. Wenn im Rahmen der Erfindung Gehäusekomponenten in Form von Seitenwänden, einer unteren Wand und einer oberen Wand vorgesehen sind, so haben diese Gehäusekomponenten lediglich eine verkleidende Funktion und/oder eine Schutzfunktion.

Der Erfindung liegt die Erkenntnis zugrunde, dass die erfindungsgemäße Zähler- und/oder Verteilervorrichtung als Ganzes sehr kompakt ausgebildet werden kann und dabei in festigkeitsmäßiger bzw. stabilitätsmäßiger Hinsicht allen Anforderungen genügt. Die Zählerkomponenten und/oder Verteilerkomponenten können funktionssicher an der rückseitigen Plattform, die die tragende Funktion der Vorrichtung übernimmt, befestigt werden. Dies erfolgt mittels kompakter und einfach transportabler Aggregate bzw. Bausätze aus den Befestigungsschienen und den Zähler- und/oder Verteilerkomponenten. Diese Aggregate bzw. Bausätze sind an der rückseitigen Plattform sehr einfach montierbar und auch wieder demontierbar. Insoweit zeichnet sich die erfindungsgemäße Vorrichtung durch Montagefreundlichkeit aus. Alle Komponenten sind für das Wartungspersonal, beispielsweise für einen Elektriker, einfach zugänglich. Die Aggregate aus Befestigungsschienen und Zähler- und/oder Verteilerkomponenten eignen sich ohne weiteres für eine Schnellmontage. Dadurch, dass erfindungsgemäß ein Gehäuse für die Zähler- und/oder Verteilervorrichtung nicht zwingend erforderlich ist, kann die Vorrichtung gegenüber den aus dem Stand der Technik bekannten Vorrichtungen mit vermindertem Materialeinsatz hergestellt werden und es versteht sich, dass hierdurch eine Kostensenkung erzielt wird.

Nachfolgend wird die Erfindung anhand einer lediglich ein Ausführungsbeispiel darstellenden Zeichnung näher erläutert. Es zeigen in schematischer Darstellung:
- **Fig. 1**: eine perspektivische Ansicht einer erfindungsgemäßen Zähler- und Verteilervorrichtung,
- **Fig. 2**: eine Explosionsdarstellung des Gegenstandes nach Fig. 1 in einer anderen Ausführungsform und
- **Fig. 3**: einen Befestigungsclip für die erfindungsgemäße Zähler- und Verteilervorrichtung.

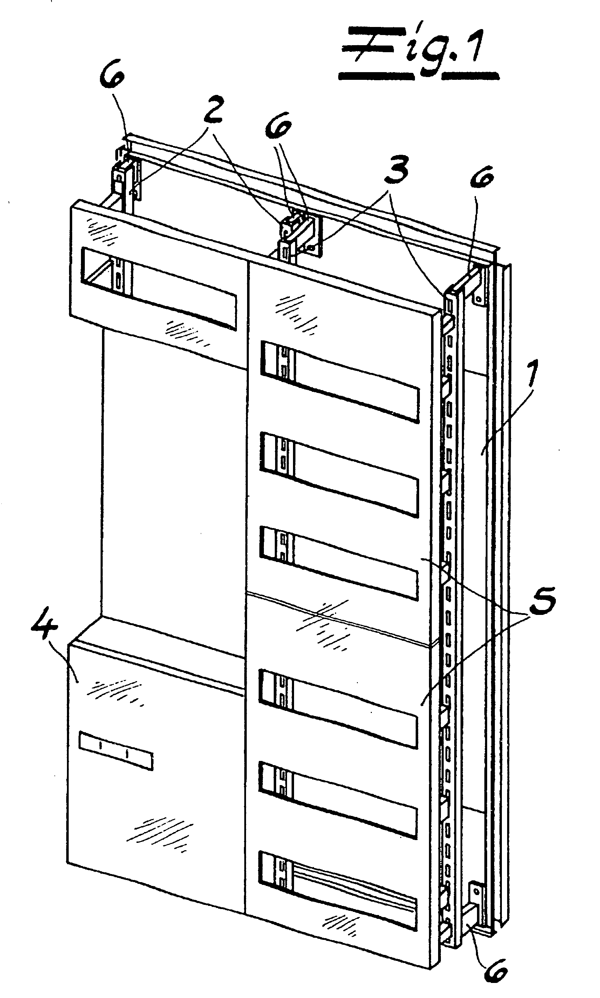

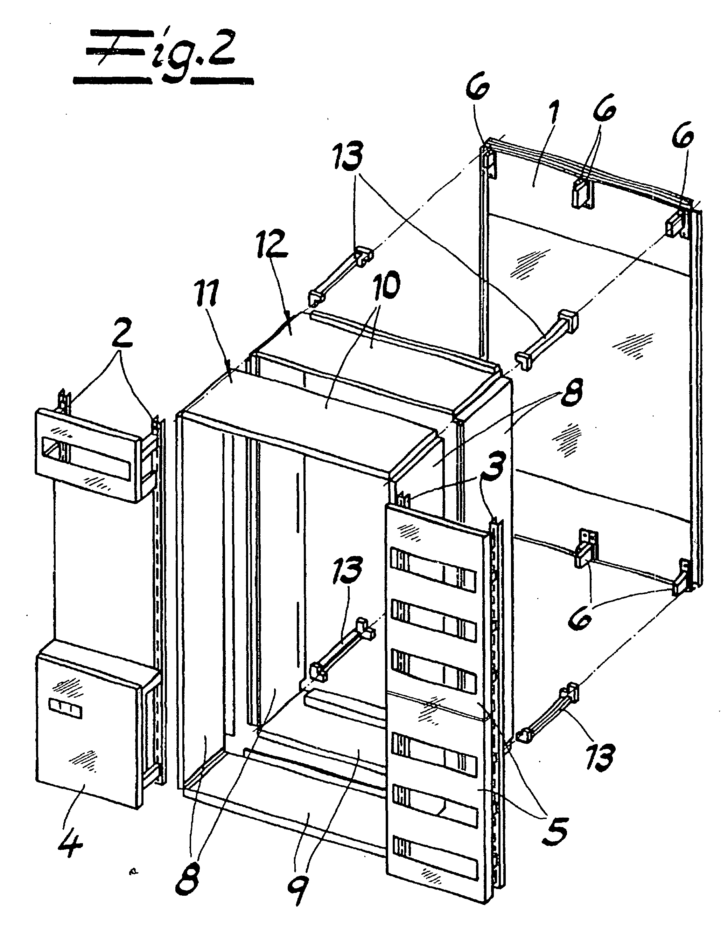

Die Fig. 1 und 2 zeigen eine erfindungsgemäße Zähler- und Verteilervorrichtung mit einer rückseitigen Plattform 1, die vorzugsweise an einer nicht dargestellten Gebäudewand befestigbar ist. Die Befestigung der rückseitigen Plattform 1 an der Wand kann beispielsweise mit Hilfe von Schrauben erfolgen. Die rückseitige Plattform 1 besteht zweckmäßigerweise und im Ausführungsbeispiel aus einem Metallblech, auf das vorderseitig eine Kunststoffschicht aufgebracht ist.

Erfindungsgemäß sind Befestigungsschienen 2, 3 vorgesehen, an denen Zählerkomponenten 4 und Verteilerkomponenten 5 befestigt sind. Insbesondere in Fig. 1 ist erkennbar, dass die Befestigungsschienen 2, 3 in dem an der rückseitigen Plattform 1 montierten Zustand vertikal ausgerichtet sind. Nach einer bevorzugten Ausführungsform und im Ausführungsbeispiel sind vier zueinander parallele Befestigungsschienen 2, 3 vorgesehen. An zwei parallelen Befestigungsschienen 2 sind die Zählerkomponenten 4 befestigt, wobei die Befestigungsschienen 2 an den Außenrändern der Zählerkomponenten 4 angeordnet sind. An zwei Befestigungsschienen 3 sind die Verteilerkomponenten 5 befestigt, wobei die Befestigungsschienen 3 ebenfalls an den Außenrändern der Verteilerkomponenten 5 angeordnet sind. Somit ergibt sich ein Aggregat aus den beiden Befestigungsschienen 2 und den Zählerkomponenten 4 und ein zweites Aggregat aus den Befestigungsschienen 3 und den Verteilerkomponenten 5 (siehe insbesondere Fig. 2). Bei den Zählerkomponenten 4 handelt es sich vorzugsweise und im Ausführungsbeispiel um Stromzählerkomponenten und bei den Verteilerkomponenten handelt es sich vorzugsweise und im Ausführungsbeispiel um Stromverteilerkomponenten.

In Ausführungsbeispiel sind die Befestigungsschienen 2, 3 über Rastverbindungen an der rückseitigen Plattform 1 befestigt. Die Befestigung der Befestigungsschienen 2, 3 erfolgt an der rückseitigen Plattform 1 ausschließlich über solche Rastverbindungen. Auf der rückseitigen Plattform 1 sind Befestigungsclips 6 vorgesehen, und die Befestigungsschienen 2, 3 sind zur Verwirklichung der Rastverbindungen mit diesen Befestigungsclips 6 verrastbar. Im Ausführungsbeispiel sind zwei Befestigungsclips 6 pro Befestigungsschiene 2, 3 vorgesehen. Die Befestigungsclips 6 können an der rückseitigen Plattform 1 angeschraubt sein.

Das Aggregat ist aus den beiden Befestigungsschienen 2 und den Zählerkomponenten 4 als Ganzes an die rückseitige Plattform 1 angedrückt wird und dabei verrastbar. Hierzu stehen im Ausführungsbeispiel vier Befestigungsclips 6 für dieses Aggregat zur Verfügung. Es liegt weiterhin im Rahmen der Erfindung, dass das Aggregat aus den Befestigungsschienen 3 und den Verteilerkomponenten 5 als Ganzes an die rückseitige Plattform 1 andrückbar und dabei verrastbar ist. Die Rastverbindungen sind auf einfache Weise wieder lösbar.

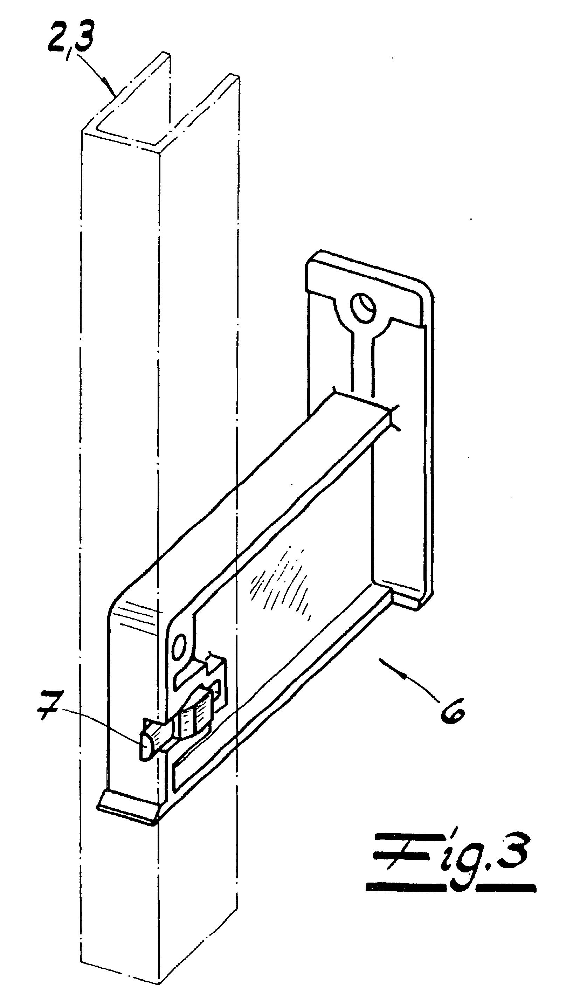

Fig. 3 zeigt eine Ausführungsform eines Befestigungsclips 6 für die erfindungsgemäße Zähler- und Verteilervorrichtung. Die Befestigungsschienen 2, 3 sind vorzugsweise und im Ausführungsbeispiel im Querschnitt U-förmig ausgebildet. Ein erfindungsgemäßer Befestigungsclip 6 fasst beim Verrasten in die offene Seite dieses U-Profils der Befestigungsschiene 2, 3 ein. Dabei wird das in Fig. 3 erkennbare Rastbauteil 7 in der Befestigungsschiene 2, 3 verrastet. Die Rastverbindung ist wieder lösbar.

Erfindungsgemäß übernimmt die rückseitige Plattform 1 allein die tragende Funktion für die Befestigungsschienen 2, 3 und für die Zählerkomponenten 4 sowie für die Verteilerkomponenten 5. Insoweit sind weitere Gehäusekomponenten grundsätzlich nicht erforderlich und die erfindungsgemäße Zähler- und/oder Verteilervorrichtung kann beispielsweise so eingesetzt werden, wie sie in der Fig. 1 dargestellt ist. In der Explosionsdarstellung nach Fig. 2 sind zusätzliche Gehäusekomponenten in Form von zwei Seitenwänden 8, einer unteren Wand 9 und einer oberen Wand 10 erkennbar, die mit der rückseitigen Plattform 1 verbunden werden können. Diesen Gehäusekomponenten kommt bezüglich der Befestigungsschienen 2, 3 und der Zählerkomponenten 4 sowie der Verteilerkomponenten 5 aber keine tragende Funktion zu. Sie übernehmen lediglich eine verkleidende Funktion bzw. eine Schutzfunktion. Im Ausführungsbeispiel werden die Seitenwände 8, die untere Wand 9 und die obere Wand 10 einerseits von einem außen angeordneten rechteckförmigen Blechrahmen 11 und andererseits von einem innen angeordneten und in den Blechrahmen 11 einpassbaren rechteckförmigen Kunststoffrahmen 12 gebildet. Im Ausführungsbeispiel wird das Aggregat aus Blechrahmen 11 und Kunststoffrahmen 12 zwischen vier Fixierungspfeilern 13 verrastet, die an den vier Ecken der rückseitigen Plattform 1 befestigt werden, zweckmäßigerweise angeschraubt werden. Auch für diese Gehäusekomponenten ist also eine Befestigung an der rückseitigen Plattform 1 über Rastverbindungen vorgesehen.

## Patentansprüche

1. Zähler- und/oder Verteilervorrichtung, mit einer rückseitigen Plattform (1), die insbesondere an einer Wand fixierbar ist,
wobei zumindest zwei Befestigungsschienen (2, 3) vorgesehen sind, an denen Zählerkomponenten (4) und/oder Verteilexkomponenten (5) befestigt sind,
wobei die Befestigungsschienen (2, 3) ihrerseits über Rastverbindungen an der rückseitigen Plattform (1) befestigt sind,
wobei auf der rückseitigen Plattform (1) Befestigungsclips (6) vorgesehen sind und wobei die Befestigungsschienen (2, 3) zur Verwirklichung der Rastverbindungen mit den Befestigungsklipps (6) verrastbar sind,
und wobei die rückseitige Plattform (1) allein die tragende Funktion für die Befestigungsschienen (2, 3) mit den Zählerkomponenten (4) und/oder Verteilerkomponenten (5) übernimmt.

2. Zähler- und/oder Verteilervorrichtung nach Anspruch 1, wobei die rückseitige Plattform (1) aus Metallblech besteht.

3. Zähler- und/oder Verteilervorrichtung nach einem der Ansprüche 1 oder 2, wobei die Befestigungsschienen (2, 3) im montierten Zustand vertikal ausgerichtet sind.

4. Zähler- und/oder Verteilervorrichtung nach einem der Ansprüche 1 bis 3, wobei zumindest vier zueinander parallele Befestigungsschienen (2, 3) vorgesehen sind und wobei jeweils zumindest eine Zählerkomponente (4) und/oder Verteilerkomponente (5) an zwei zueinander parallelen Befestigungsschienen (2, 3) befestigt ist.

5. Zähler- und/oder Verteilervorrichtung nach Anspruch 4, wobei ein Aggregat aus zwei zueinander parallelen Befestigungsschienen (2, 3) und zumindest einer daran befestigten Zählerkomponente (4) und/oder Verteilerkomponente (5) als Ganzes an der rückseitigen Plattform (1) verrastbar ist.

6. Zähler- und/oder Verteilervorrichtung nach einem der Ansprüche 1 bis 5, wobei Gehäusekomponenten in Form von zwei Seitenwänden (8), einer unteren Wand (9) und einer oberen Wand (10) an der rückseitigen Plattform (1) befestigt sind.

## Claims

1. A metering and/or distributing device with a rear platform (1) that is more specifically fixable to a wall,
wherein at least two securing rails (2, 3) are provided to which are secured the meter components (4) and/or the distributor components (5),
wherein said securing rails (2, 3) are in turn secured to the rear platform (1) through snap connections,
wherein securing clips (6) are provided on the rear platform (1) and wherein said securing rails (2, 3) are snappable into the securing clips (6) to establish the snap connections,
and wherein the rear platform (1) performs the function of carrying the securing rails (2, 3) with the meter components (4) and/or the distributor components (5) alone.

2. The metering and/or distributing device according to claim 1, wherein the rear platform (1) consists of sheet metal.

3. The metering and/or distributing device according to one of the claims 1 or 2, wherein the securing rails (2, 3) are aligned vertically in the mounted condition.

4. The metering and/or distributing device according to one of the claims 1 through 3, wherein at least four paralleled securing rails (2, 3) are provided and wherein at least one meter component (4) and/or distributor component (5) are respectively secured to two paralleled securing rails (2, 3).

5. The metering and/or distributing device according to claim 4, wherein a group consisting of two paralleled securing rails (2, 3) and of at least one meter component (4) and/or distributor component (5) secured thereon is snappable as a whole to the rear platform (1).

6. The metering and/or distributing device according to one of the claims 1 through 5, wherein housing components in the form of two side walls (8), one bottom wall (9) and one top wall (10) are secured to the rear platform (1).

## Revendications

1. Dispositif de comptage et/ou de distribution avec une plate-forme arrière (1) adaptée pour être fixée à un mur,
où au moins deux rails de fixation (2, 3) sont prévus sur lesquels sont fixés les éléments constitutifs du compteur (4) et/ou les éléments constitutifs du distributeur (5),
où les rails de fixation (2, 3) sont à leur tour fixés sur la plate-forme arrière (1) par l'intermédiaire de liaisons par encliquetage,
où des clips de fixation (6) sont prévus sur la plate-forme arrière (1) et où les rails de fixation (2, 3) sont adaptés pour être encliquetés dans les clips de fixation (6) pour établir les liaisons par encliquetage,
et où la plate-forme arrière (1) assure seule la fonction consistant à porter les rails de fixation (2, 3) avec les éléments constitutifs du compteur (4) et/ou les éléments constitutifs du distributeur (5).

2. Dispositif de comptage et/ou de distribution selon la revendication 1, où la plate-forme arrière (1) est réalisée en tôle métallique.

3. Dispositif de comptage et/ou de distribution selon l'une quelconque des revendications 1 ou 2, où les rails de fixation (2, 3) sont alignés verticalement quand ils sont assemblés.

4. Dispositif de comptage et/ou de distribution selon l'une quelconque des revendications 1 à 3, où au moins quatre rails de fixation (2, 3) parallèles sont prévus et où au moins un élément constitutif du compteur (4) et/ou un élément constitutif du distributeur (5) est respectivement fixé à deux rails de fixation (2, 3) parallèles.

5. Dispositif de comptage et/ou de distribution selon la revendication 4, où un ensemble composé de deux rails de fixation (2, 3) parallèles et d'au moins un élément constitutif du compteur (4) et/ou élément constitutif du distributeur (5) est adapté pour être encliqueté en tant qu'ensemble sur la plate-forme arrière (1).

6. Dispositif de comptage et/ou de distribution selon l'une quelconque des revendications 1 à 5, où des éléments constitutifs du boîtier sont fixés sous forme de deux parois latérales (8), d'une paroi inférieure (9) et d'une paroi supérieure (10) sur la plate-forme arrière (1).
